# EUROPEAN PATENT APPLICATION

(11) **EP 4 092 648 A1**
(43) Date of publication of application: **23.11.2022**
(21) Application number: 21740980.4
(22) Date of filing: 13.01.2021
(51) Int. Cl.: G08C 17/02

(54) **METHOD FOR DISPLAYING MEASUREMENT PARAMETER, AND DEVICE**

(30) Priority: 14.01.2020 CN 202010038290
(71) Applicant: Schneider Electric Industries SAS, 92500 Rueil-Malmaison (FR)
(72) Inventor: QIU, Jian, Shanghai 201203 (CN); TIAN, Jianwei, Shanghai 201203 (CN)
(74) Representative: Murgitroyd & Company
(86) International application number: PCT/CN2021/071463
(87) International publication number: WO 2021/143720

(57) **Abstract**

Embodiments of the present disclosure provide a method and apparatus for displaying measurement parameters. The method comprises: in response to receiving an input signal indicating to display one or more measurement parameters of an electrical device, reading from a memory a first data associated with the one or more measurement parameters for display, and generating an update request for the first data; sending the update request to the electrical device; and in response to receiving, from the electrical device, a second data associated with the one or more measurement parameters, writing the second data to the memory as updated data to replace the first data. According to embodiments of the present disclosure, a large amount of measurement data of a power distribution system can be collected and displayed, data display is decoupled from data communication, and the impact of communication delay is eliminated, thereby improving the user's experience.

## Description

### FIELD

Embodiments of the present disclosure relate to the field of power distribution systems, and more specifically to a method and apparatus for displaying measurement parameters of an electrical device in a power distribution system.

### BACKGROUND

In some cases, electrical parameters (such as energy consumption, power, voltage, etc.) of an electrical device in a power distribution system need to be displayed. For example, in some countries or regions, laws and regulations mandate that measurement data of load energy consumption be displayed locally (e.g., at a distribution cabinet or at a position nearby the distribution cabinet) to measure the energy consumption of a residence.

A traditional power distribution system usually employs a pointer-type meter or a digital display meter. However, the traditional meter can only display the parameters of the electrical device in the power distribution system to a limited extent. For example, a traditional single display meter can only display a small number of electrical parameters. Furthermore, one display meter or display terminal usually corresponds to one electrical device. Therefore, if there are a plurality of electrical devices that need to display a plurality of parameters, a large number of display meters or display terminals are needed. Therefore, in the traditional solution, the efficiency of displaying measurement data and querying measurement data is very low. In the case of interconnecting the display terminal with the power distribution system in a wired communication manner, the traditional solution will also lead to complicated wiring and installation, and may even affect the operation and maintenance of the power distribution system.

### SUMMARY

In view of the above problems, example embodiments according to the present disclosure provide a method and apparatus for displaying measurement parameters.

In a first aspect of the present disclosure, there is provided a method for displaying measurement parameters. The method comprises: in response to receiving an input signal indicating to display one or more measurement parameters of an electrical device, reading from a memory a first data associated with the one or more measurement parameters for display, and generating an update request for the first data; sending the update request to the electrical device; and in response to receiving, from the electrical device, a second data associated with the one or more measurement parameters, writing the second data to the memory as updated data to replace the first data.

With a function of buffering the measurement data in the memory in advance and then updating the measurement data being provided, data display may be decoupled from data communication, so the user needn't wait for a response from a remote electrical device, and the user's experience is improved.

In some embodiments of the present disclosure, sending the update request to the electrical device comprises: determining a device group to which the electrical device belongs based on the electrical device whose one or more measurement parameters are involved in the update request; pushing the update request into a request queue corresponding to the device group; and sending the update request to the electrical device according to the request queue. Through this embodiment, a plurality of electrical devices in a power distribution system may be classified into one or more device groups, and requests for updating data can be sequentially processed based on the device groups, thereby improving the efficiency in updating and displaying measurement data, and ensuring the order and accuracy of the updated data.

In certain embodiments of the present disclosure, sending the update request to the electrical device according to the request queue comprises: determining whether a value of a timer corresponding to the request queue is equal to zero, wherein the value equal to zero indicates a data transceiver for sending the update request is in an idle state; and in response to the value of the timer being equal to zero, sending the update request to the electrical device via the data transceiver. In the present embodiment, whether a previous request is completed can be determined by the value of the timer, thereby ensuring the accuracy and sequential reception and transmission of the data.

In some embodiments of the present disclosure, the method further comprises: in response to the update request being sent, the timer starts to keep time. In this embodiment, a waiting time after the update request is sent may be determined by the timer.

In some embodiments of the present disclosure, the method further comprises: in response to the value of the timer exceeding a threshold, removing the corresponding update request from the request queue, and resetting the timer to zero to send next update request, wherein the value exceeding the threshold indicates that the data transceiver has not received from the electrical device the second data as the updated data. Through the embodiment, it is possible to avoid reduction of the efficiency of the system due to unlimited wait for the response.

In certain embodiments of the present disclosure, the method further comprises: in response to receiving the second data associated with the one or more measurement parameters from the electrical device, removing the corresponding update request from the request queue, and resetting the timer to zero to send next update request. With this embodiment, once it is determined that a response to the update request has been received, the timer may be reset to wait for the sending of next update request.

In certain embodiments of the present disclosure, the method further comprises: in response to the data received from the electrical device being identified as a notification signal indicative of a fault, displaying information associated with the fault indicated by the notification signal. In this embodiment, what is received by the display device is the notification signal indicating the fault instead of the updated data, the fault information is displayed immediately to remind the user.

In some embodiments of the present disclosure, displaying the information associated with the fault indicated by the notification signal comprises: obtaining corresponding fault information through a look-up table based on the notification signal; and displaying the obtained fault information. Through this embodiment, fault information may be efficiently determined by querying a notification list.

In some embodiments of the present disclosure, the method further comprises: in response to the data received from the electrical device being identified as a control signal, performing a display-related operation or a communication-related operation based on the control signal. In this embodiment, the display and communication of the display device may be operated through the control signal, thereby providing a more flexible option.

In some embodiments of the present disclosure, the display-related operation comprises highlighting the display, and the communication-related operation comprises cutting off a communication connection with the electrical device. Through this embodiment, when there are multiple display devices, the display device associated with the electrical device to be looked up may be quickly found, and the communication connection can be cut off from the electrical device side, thereby providing the user with a more flexible operations option.

In some embodiments of the present disclosure, sending the update request to the electrical device further comprises: sending the update request to the electrical device via a wireless communication channel. Through this embodiment, the connection of cables may be avoided, and the difficulty in installation may be reduced.

In certain embodiments of the present disclosure, the wireless communication channel is a communication channel established using Zigbee technology. In this embodiment, the interaction mode and communication mode are designed by using a standardized wireless communication protocol, which effectively increases the communication efficiency and facilitates fast access to the wireless system.

In some embodiments of the present disclosure, the electrical device comprises a gateway for establishing a communication channel. Through this embodiment, the user may also look up the status of the gateway.

In certain embodiments of the present disclosure, the electrical device comprises at least one of an electrical load and a power distribution device. In this embodiment, the display device may be used to monitor the electrical load and the power distribution device in the electrical system or the power distribution system to effectively display the parameters of these devices.

According to a second aspect of the present disclosure, there is provided an apparatus for displaying measurement parameters. The apparatus comprises: a processor; and a memory coupled to the processor, the memory having stored therein instructions that, when executed by the processor, cause the apparatus to perform actions comprising: in response to receiving an input signal indicating to display one or more measurement parameters of an electrical device, reading from a memory a first data associated with the one or more measurement parameters for display, and generating an update request for the first data; sending the update request to the electrical device; and in response to receiving, from the electrical device, a second data associated with the one or more measurement parameters, writing the second data to the memory as updated data to replace the first data.

It should be appreciated that this Summary is not intended to identify key features or essential features of the claimed subject matter, nor is it intended to be used to limit the scope of the claimed subject matter. Other features of this Summary will be made apparent through the following depictions.

### BRIEF DESCRIPTION OF THE DRAWINGS

Through the following detailed description with reference to the accompanying drawings, the above and other features, advantages and aspects of various embodiments of the present disclosure will become more apparent. Throughout the drawings, the same reference symbols generally refer to the same elements, wherein
FIG. 1 shows a schematic diagram of a system in which an embodiment of the present disclosure may be implemented;
FIG. 2 shows a schematic block diagram of a method for displaying measurement parameters according to an embodiment of the present disclosure;
FIG. 3 shows a schematic diagram of data flow in a display device according to an embodiment of the present disclosure;
FIG. 4 shows a schematic diagram of data flow in a buffer management unit of a display device according to an embodiment of the present disclosure;
FIG. 5A through FIG. 5E exemplarily illustrate a user interface of a display device according to an embodiment of the present disclosure; and
FIG. 6 shows a schematic block diagram of an example device that may be used to implement an embodiment of the present disclosure.

### DETAILED DESCRIPTION OF EMBODIMENTS

Embodiments of the present disclosure will be described in more detail below with reference to the figures. While certain embodiments of the present disclosure are shown in the figures, it should be appreciated that the present disclosure may be embodied in various forms and should not be construed as being limited to the embodiments set forth herein, and instead, these embodiments are provided for a more thorough and complete understanding of the present disclosure. It should be appreciated that the drawings and embodiments of the present disclosure are only used for exemplary purposes, and are not intended to limit the protection scope of the present disclosure.

As used herein, the term "comprises" and its variants are to be read as open-ended terms that mean "comprises, but is not limited to." The term "based on" is to be read as "based at least in part on." The term "one example embodiment" and "an example embodiment" are to be read as "at least one example embodiment." Terms "a first", "a second" and others can denote different or identical objects. The following text may also contain other explicit or implicit definitions.

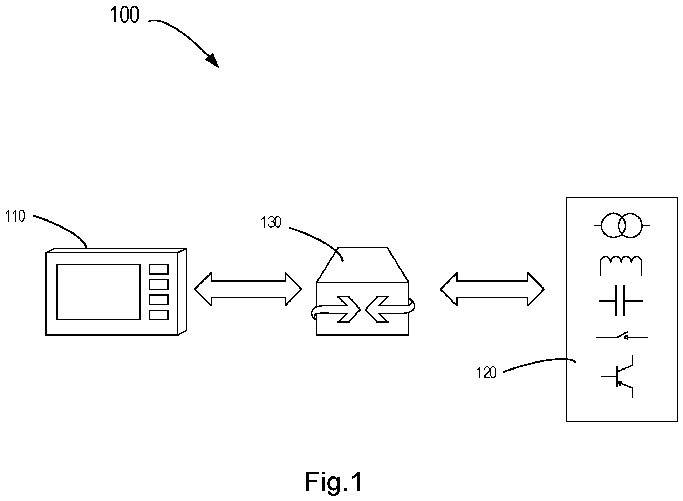

FIG. 1 shows a schematic diagram of a system 100 in which an embodiment of the present disclosure may be implemented. System 100 may include a display device 110 and an electrical system 120. The display device 110 is used to display measurement parameters regarding the electrical device for the user to look up, and the user may also operate the display device by pressing a key or in other input manners to set the display device. In addition, the number of the display devices 110 may be one or more as needed. The electrical system 120 may have one or more electrical devices, which may for example include various electrical loads, and may also include power distribution devices such as circuit breakers, transformers, electrical or electronic devices, and the like. Each electrical device in the electrical system 120 may have a corresponding measuring device (not shown in the figure) for measuring electrical parameters of each electrical device. The electrical parameters to be measured for example include electrical quantities such as energy consumption (kWh), active power (kW), reactive power (kVar), voltage (V) and current (A). However, it is appreciated that the electrical devices and electrical parameters herein are not limited to those exemplified above, and instead, the electrical devices may be any devices present in the electrical system or power distribution system, and the electrical parameters may be any performance or state parameters to be measured and displayed.

The system 100 may further include a gateway 130. The display device 110 and the electrical device (or a measuring device of the electrical device) in the electrical system 120 each have a communication unit for realizing wired communication or wireless communication. Thus, the display device 110 and the electrical device in the electrical system 120 are communicatively connected via the gateway 130 in a wired or wireless manner. Specifically, the gateway 130 may be communicatively connected to the electrical device of the electrical system or the measuring device of the electrical device to obtain electrical parameters or other parameters to be displayed. Meanwhile, the gateway 130 may be communicatively connected to the display device 110 to transmit the obtained parameters to the display device 110, so that the display device 110 displays the parameters needed by the user. In addition, the gateway 130 may also be communicatively connected to a server (not shown in FIG. 1), such as a cloud server, to obtain data from the server or store related data in the server. However, it may be appreciated that the display device 110 may also be directly communicatively connected to the electrical device (or the measuring device of the electrical device) in the electrical system 120 in a wireless or wired manner without using the gateway 130.

In some cases, due to the delay of communication between the display device and the electrical system, the user needs a long time to wait for the data to be transmitted from the remote electrical device to the display device when looking up the measurement parameters, which degrades the user's experience. In addition, as mentioned above, in the case where multiple parameters of multiple electrical devices need to be displayed, multiple display devices might be needed to display these parameters, which causes a lower display efficiency and query efficiency.

The present disclosure provides a solution for displaying measurement parameters. In the solution of the present disclosure, with a data buffer function being provided in the display device, when the user wants to look up the measurement parameters, it may directly read the data of the previously-stored measurement parameters, and immediately display the read data, and meanwhile send a data-updating request to the remote electrical device to update the previously-stored data. Thus, the user does not need to wait for a remote response, thereby avoiding the influence of communication delay and effectively improving the user's experience. In addition, the solution of the present disclosure may also classify the devices in the power distribution system to form one or more device groups, and display and update the measurement data according to the device groups, whereby one or a small number of display devices may collect and display almost all measurement data in the power distribution system.

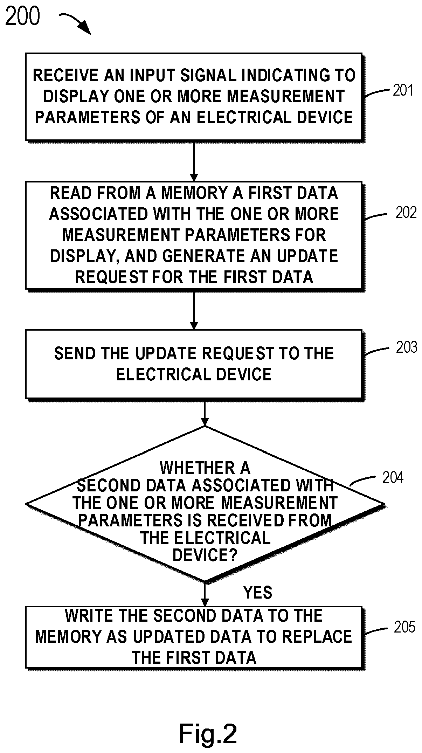

FIG. 2 shows a schematic block diagram of a method 200 for displaying measurement parameters according to an embodiment of the present disclosure. The method 200 may be implemented in system 100 in FIG. 1 and performed by a processor of the display device 110. The method 200 will be described with reference to FIG. 1 for ease of discussion.

At block 201, an input signal indicative of displaying one or more measurement parameters of the electrical device is received.

When the user needs to look up the measurement parameters (such as energy consumption) of the electrical device, the display device 110 in FIG. 1 may access to an already-existing wireless system (the wireless system may include the gateway 130 and an electrical device of the electrical system 120 communicatively connected with the gateway 130). For example, the display device 110 may be connected to the gateway 130 as a routing node of a Zigbee wireless system. Specifically, the display device 110 may find a wireless system that meet requirements by searching a network, and the display device 110 may process by taking EPID: 105E authenticated by Schneider as a first priority level. The gateway 130 may be a Smartlink SI DIN and the wireless system may be a star network. It may be appreciated that the above manner of accessing the network is only exemplary, and any other suitable manner may also be used to establish a wireless or wired communication connection between the display device 110 and the devices of the electrical system 120.

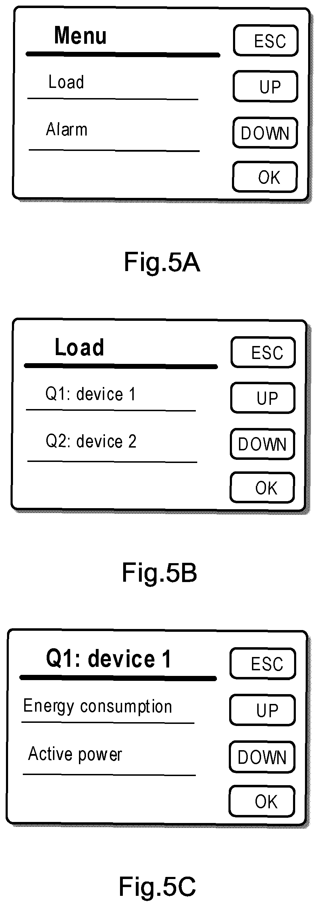

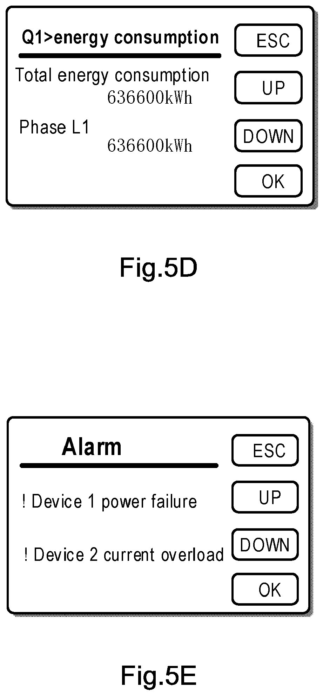

After the communication connection is established, the user may send an input signal to the display device 110 through a certain operation, the input signal indicating to display the measurement parameters of the electrical device. For example, a user may issue such an input signal by operating a user interface of the display device 110. FIG. 5A through FIG. 5E exemplarily illustrate a user interface of the display device 110. As shown in FIG. 5A, there are multiple virtual buttons on the right side of the user interface, and the virtual buttons may include ESC, up, down, and OK. These virtual buttons may be operated through a small number of physical keys, to select options on the left side of the user interface. By selecting these options on the left side of the user interface, the user may find the measurement parameters of the electrical device that he wants to look up. After the user selects the option of the parameter to be looked up (e.g. as shown in FIGS. 5C and 5D, the user chooses to look up the energy consumption parameter of Q1), the display device 110 will receive an input signal instructing to display the measurement parameter. It may be appreciated that the user may also operate the user interface in any suitable manner, such as a touch screen, a keyboard, a mouse, etc., to send the above-mentioned input signal. In addition, the input signal may also be generated by manually operating a specific key or button on the display device 110. In addition, the user may also send the above-mentioned input signal to the display device 110 in other ways, for example, the user may send such an input signal through a mobile terminal or other electronic devices.

In some embodiments of the present disclosure, the electrical device in the electrical system 120 shown in FIG. 1 may include at least one of an electrical load and power distribution device. For example only, electrical load may include a household load and an industrial load, and the power distribution device may include devices such as a transformer, a circuit breaker, and an electrical and electronic device. The display device 110 may be used to display the measurement parameters of the electrical load and the power distribution device in the electrical device 120, thereby helping the user to acquire the working conditions of the electrical load and the power distribution device.

In some embodiments of the present disclosure, the electrical device may include a gateway 130 for establishing a communication channel. Specifically, the display device 110 may also acquire and display the measurement parameters of the gateway 130, thereby helping the user to acquire the working conditions of the gateway 130.

In some embodiments of the present disclosure, the display device 110 receives a character code from the gateway 130 to display the character code as it is, the character code indicating descriptive information associated with the electrical device. Specifically, the display device 110 may communicate with other devices via the gateway 130, and the display device 110 may acquire, from the gateway 130, descriptive information of all other devices connected to the gateway 130. Such descriptive information for example may include which device groups the electrical devices connected to the gateway 130 are divided into, which devices are included in each device group, and which measurement parameters the electrical devices have. The gateway 130 may send the descriptive information to the display device 110 as character codes, and the display device 110 may display the received character codes as they are (e.g., the text content shown in FIG. 5A through FIG. 5E ). For example, if the character code sent by the gateway 130 is English (for example, the gateway may have a web configuration page to set a language type), the display device 110 will also display English as it is. In some embodiments, the character code may be a Unicode encode. By transmitting the Unicode encode between the gateway and the display device, the display device 110 may display different languages in the world, so that the display device 110 may be suitable for different countries and regions.

At block 202, a first data associated with one or more measurement parameters is read from a memory for display, and an update request for the first data is generated.

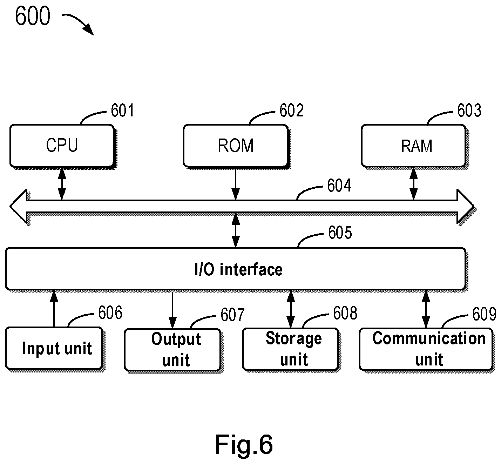

After the display device 110 receives an input signal or request for displaying measurement parameters of the electrical device, the display device 110 will read the previously-stored measurement data of the electrical device from the display device's own memory. At the same time, the display device 110 will generate an update request for updating the first data. Therefore, when the user needs to look up the measurement parameters, the display device 110 may immediately acquire the measurement data and display it to the user, thereby avoiding the influence of communication delay. Although the measurement data displayed by the first input signal (or the display request) is the previously-stored data, the display device 110 also simultaneously generates an update request to obtain the latest measurement data. The above-mentioned memory in the display device 110 for storing measurement data for example includes, but is not limited to a memory such as a solid-state memory, an electromagnetic memory, an optical memory, or combinations of these forms of memories, and may also be a volatile memory, a non-volatile memory, or combinations of these types of memories. In order to improve the speed in reading and writing data, the memory for storing the measurement data may be of a memory type with a higher access speed, for example, the memory may be a buffer memory (including a cache memory), or may be a Random Access Memory (RAM) shown in FIG. 6.

At block 203, the update request is sent to the electrical device.

After the update request is generated, the display device 110 will send the update request to the electrical device to obtain updated measurement data from the electrical device. Specifically, the display device 110 may send a request for updating the measurement data to the gateway 130 in a wired or wireless communication manner. For example, the display device 110 may wirelessly communicate with the gateway 130 based on a Zigbee network to send the update request. Then, the gateway 130 will obtain the update data from the corresponding electrical device according to the request. It may be appreciated that the display device 110 may also directly send an update request for updating data to the electrical device without requiring a separate gateway.

In some embodiments of the present disclosure, sending the update request to the electrical device further comprises: sending the update request to the electrical device via a wireless communication channel. The wireless communication may avoid the connection of cables and reduce the difficulty of installation. In some embodiments, the wireless communication channel is a communication channel established using a Zigbee technology. As an example, the display device 110 in the present disclosure may perform wireless communication based on a Zigbee tunneling protocol, and may utilize a Non-Flow Control mode in a Tunnelling attribute in a Smart Energy Cluster of the Zigbee standard. The interaction mode and communication mode are designed by using a standardized wireless communication protocol, which effectively increases the communication efficiency and facilitates fast access to the wireless system.

In some embodiments of the present disclosure, sending the update request to an electrical device includes: determining a device group to which the electrical device belongs based on the electrical device whose one or more measurement parameters are involved in the update request; pushing the update request into a request queue corresponding to the device group; and sending the update request to the electrical device according to the request queue.

When the display device 110 needs to display the parameter conditions of multiple electrical devices, the display device 110 may classify the multiple electrical devices to form one or more device groups, wherein each device group may include one or more electrical devices. Based on which electrical device whose measurement parameters are to be displayed, the display device 110 may determine the device group corresponding to this electrical device. For each device group, the display device 110 may be provided with a request queue (e.g., a first-in first-out queue). Since the display device 110 may receive multiple update requests for updating the same measurement parameter or different measurement parameters of the electrical devices in the device group, the request queue may buffer these update requests in sequence, and process and send them in sequence.

In some embodiments of the present disclosure, sending the update request to the electrical device according to the request queue includes: determining whether a value of a timer corresponding to the request queue is equal to zero, wherein the value equal to zero indicates a data transceiver for sending the update request in an idle state; and in response to the value of the timer being equal to zero, sending the update request to the electrical device via the data transceiver.

Specifically, in order to ensure accurate transmission and reception of data, after sending an update request the corresponding data transceiver for the request queue usually processes next update request after receiving a response to the update request. To this end, a timer is set for each request queue. When the value of the timer is not zero, this indicates that the data transceiver of the display device 110 is waiting for the response to the last update request; and when the value of the timer is zero, this indicates that the data transceiver is in an idle state, that is, the data transceiver is not in a state of waiting for the response. When the data transceiver is in the idle state, the display device 110 may send an update request to the electrical device.

In some embodiments of the present disclosure, in response to the update request being sent, the timer starts to keep time. Specifically, after the update request in the request queue is sent, the timer starts to keep time, so that the time for waiting for the response after the update request is sent may be determined, to avoid reduction of the efficiency due to unlimited wait for the response. In addition, based on the value of the timer, it is also possible to prompt whether the data transceiver of the request queue is idle, to avoid sending the next update request without receiving the response, thereby ensuring that multiple update requests are processed sequentially.

In some embodiments of the present disclosure, in response to the value of the timer exceeding a threshold, the corresponding update request is removed from the request queue, and the timer is reset to zero to send the next update request. If the value exceeds a threshold, this indicates that the data transceiver has not received the second data as the updated data from the electrical device. Specifically, the threshold may be set for the timer of each request queue. The threshold may be set as needed, for example, the threshold of the timer may be set based on an actual communication delay time of the corresponding device group. When the value of the timer exceeds the threshold, this indicates that no response to the update request has been received within a certain period of time. To ensure communication efficiency, the corresponding update request may be removed from the request queue, and the timer may be reset to zero. Thus, the next update request may be sent sequentially.

At block 204, determination is made as to whether a second data associated with the one or more measurement parameters is received from the electrical device.

After sending the update request, the display device 110 will wait for a response, and determine whether the received data is a response which is awaited and to the sent update request.

At block 205, in response to receiving the second data associated with the one or more measurement parameters from the electrical device, the second data is written to a memory as the updated data to replace the first data.

When a second data associated with one or more measurement parameters is received by the display device 110 (e.g., via a data transceiver that corresponds to the request queue for sending the request), the second data will replace data already stored in the memory as the updated data. Thus, when an input signal (or a display request) for displaying measurement data is received from the user again, the display device 110 may display the updated data to the user, and generate a new update request again. Usually, when the user looks up the measurement parameters through the display device, based on the user's viewing operation, the display device 110 receives a plurality of consecutive input signals (or display requests) indicating to display the measurement parameters. For example, if the user interface is left on an energy consumption page of Q1 shown in FIG. 5D for an enough long time, the display device 110 will constantly receive input signals (or display requests) indicating to display the energy consumption parameter of Q1 at a certain time interval, and accordingly generate multiple update requests to update the measurement data in memory. Therefore, the display device 110 can constantly display the updated data, and avoid the influence of the communication delay on the parameter display.

In some embodiments of the present disclosure, in response to receiving the second data associated with the one or more measurement parameters from the electrical device, the corresponding update request is removed from the request queue and the timer is reset to zero to send next update request. Specifically, when the updated data associated with the measurement parameter for the update request is received from the electrical device (e.g., via the gateway 130), this indicates that the request queue has completed processing the update request. Then, the update request may be removed from the request queue, and the timer may be reset to zero, whereby next update request may be sent at any time.

In some embodiments of the present disclosure, in response to the data received from the electrical device being identified as a notification signal indicating a fault, information associated with the fault indicated by the notification signal is displayed.

Specifically, when the display device 110 receives data from the electrical device, the data might not be the updated data, but a notification signal regarding a fault of the electrical device. It may be appreciated that the notification signal may be sent to the display device 110 when the electrical device fails, and needn't be triggered by the user's operation on the display device 110, and the electrical device that sends the notification signal may be any device communicatively connected to the display device 110. When the display device 110 receives such a notification signal, the display device 110 may immediately display fault information, thereby reminding the user that one or some of the electrical devices are faulty.

In some embodiments of the present disclosure, displaying the information associated with the fault indicated by the notification signal includes: obtaining corresponding fault information through a look-up table based on the notification signal; and displaying the obtained fault information. As an example, the display device 110 may have a predefined notification list. The notification list may include correspondence relationships between various notification signals and specific fault information. Upon receiving the notification signal, the display device 110 may find specific fault information based on the received notification signal, and display the corresponding fault information.

In some embodiments of the present disclosure, in response to the data received from the electrical device being identified as a control signal, a display-related operation or a communication-related operation is performed based on the control signal. Specifically, when the display device 110 receives data from the electrical device, the data may not be updated data, nor a notification signal indicating a fault, but a control signal for the display-related operation or communication-related operation. In some embodiments, the display-related operation includes highlighting the display, and the communication-related operation includes cutting off a communication connection with the electrical device.

For example, in some cases, there may be more display devices, and the user cannot determine which display device is associated with the electrical device to be looked up. In this case, a control signal may be sent from the electrical device to be looked up to the associated display device, and based on the control signal, the associated display device may be highlighted in any suitable manner, such as flashing the screen, thereby helping the user to determine the associated display device. In addition, a control signal for cutting off the communication connection may also be sent from the electrical device, and based on the control signal, the display device 110 may cut off the communication connection with the electrical system 120 or the gateway 130. It may be appreciated that the control signal may also be sent via other terminals connected to the wireless network and sent to the display device through the electrical device.

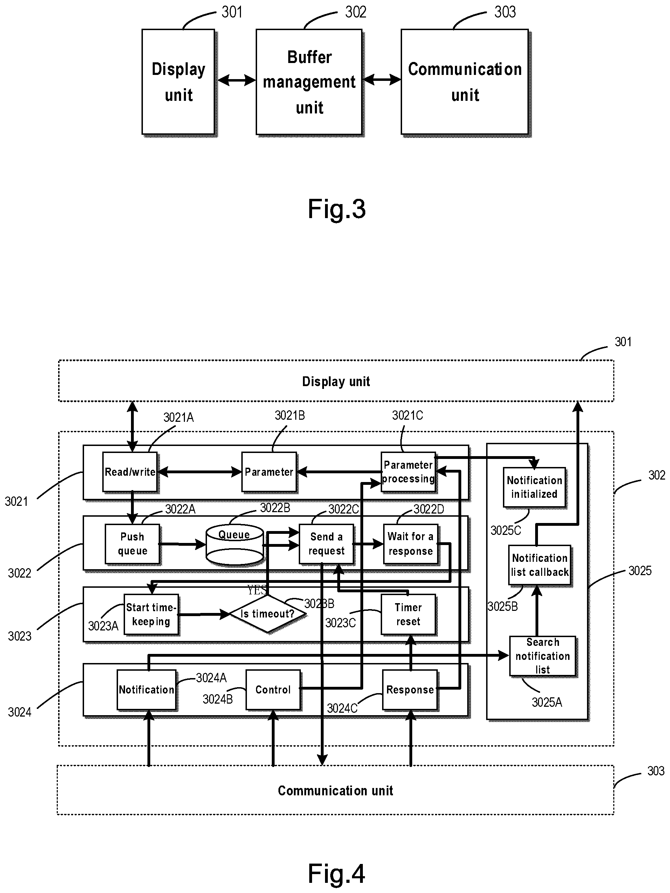

FIG. 3 shows a schematic diagram of data flow in the display device 110 according to an embodiment of the present disclosure, and FIG. 4 shows a schematic diagram of data flow in a buffer management unit of the display device 110 according to an embodiment of the present disclosure. FIG. 3 and FIG. 4 exemplarily illustrate some internal units, modules or blocks of the display device 110, and these units, modules or blocks may be implemented in a software or hardware manner. However, it may be appreciated that the units, modules or blocks in the display device shown in FIG. 3 and FIG. 4 are only exemplary and not restrictive. As such, the display device 110 may be constructed in any manner capable of implementing the method 200, and the display device 110 may include any other units, modules or blocks different from the units, modules or blocks shown in FIG. 3 and FIG. 4.

As shown in FIG. 3, the display device may include a display unit 301, a buffer management unit 302 and a communication unit 303. The display unit 301 may include a display screen to display measurement parameters to the user. The communication unit 303 is communicatively connected to other external devices, for example, to the gateway 130 or an electrical device in the electrical system 120. The communication unit 303 for example may be a Zigbee transceiver unit. The buffer management unit 302 is used to connect the data flow between the display unit 301 and the communication unit 303. The buffer management unit 302 may classify all electrical devices associated with the display device into one or more device groups, and each device group may include one or more electrical devices. Thus, the buffer management unit 302 may process the task of displaying the measurement parameters with the device group as a unit. In the buffer management unit 302, one device group may correspond to one "node". Therefore, the buffer management unit 302 may have one or more nodes. Each node of the buffer management unit 302 includes a plurality of modules. As shown in FIG. 4, each node of the buffer management unit 302 may include a storage module 3021, a sending module 3022, a timing module 3023, a receiving module 3024 and a notification module 3025. For the purpose of brevity and clarity, only one node in the buffer management unit 302 is shown in FIG. 4. The data flow in the display device upon displaying the measurement parameters will be described below by way of example.

As shown in FIG. 4, the display unit 301 sends the buffer management unit 302 an input signal or a display request for displaying the measurement parameters of a certain electrical device. The buffer management unit 302 determines the device group corresponding to the electrical device, and sends the input signal or display request to the corresponding node. After a read/write block 3021A of the storage module 3021 at the node receives the input signal or display request, the read/write block 3021A reads stored parameter values from the parameter block 3021B and sends the read parameter values to the display unit 301 for displaying, wherein the parameters in the parameter block 3021B may include data such as an ID, a name, measurement parameter values, etc. of the device. At the same time, the buffer management unit 302 or the storage module 3021 will generate an update request, and send the update request to the sending module 3022. A push queue block 3022A of the sending module 3022 pushes the update request into a queue block 3022B. A request sending block 3022C sends the update requests in the queue 3022B to the communication unit 303 in the order in the queue. Meanwhile, a response awaiting block 3022D sends a signal to a timing-starting block 3023A of the timing module 3023 to start counting time, and then a timing-judging block 3023B determines whether the timer has timed out. Once the time-out is determined, the update request waiting for a response may be removed from the queue 3022B, and next update request is sent. In addition, when the communication unit 303 receives data, the data is sent to the receiving module 3024 of the buffer management module 302. A response block 3024C of the receiving module 3024 determines that what is received is updated data regarding the update request. Then, the response block 3024C sends the updated data to a parameter processing block 3021C, and the parameter values in the parameter block 3021B are updated by the parameter processing block 3021C to replace previous parameter values. At the same time, the response block 3024C further sends a signal to a timer reset block 3023C of the timing module 3023 to reset the timer.

As shown in FIG. 4, the communication unit 303 may send the received data to the receiving module 3024. If the notification block 3024A in the receiving module 3024 determines the data as a notification signal indicating a fault, the receiving module 3024 may send the received notification signal to a notification module 3025, and a search block 3025A of the notification module 3025 will search in a notification list based on the notification signal to determine specific fault information. Then, the search block 3025A sends a search result to a notification list callback block 3025B, and the block 3025B sends the specific fault information to the display unit 301 for displaying. In addition, the parameter processing block 3021C of the storage module 3021 may send information related to the device and parameters to an initialization block 3025C of the notification module 3025 to initialize the notification module 3025 and generate the above-mentioned notification list.

As shown in FIG. 4, the communication unit 303 may send the received data to the receiving module 3024. If the control block 3024A in the receiving module 3024 determines the data as a control signal, the receiving module 3025 may send the received control signal to the parameter processing block 3021C of the storage module 3021. The parameter processing block 3021C may then modify control parameters in the parameter block 3021B based on the control signal, wherein the parameters in the parameter block 3021B may include control parameters in addition to the measurement parameters of the electrical device. The control operations on the display unit 301 and the communication unit 303 may be implemented by modifying the corresponding control parameters. The control operation for example may include highlighting the display unit 301, and cutting off the communication connection with the external device through the communication unit 303.

FIG. 5A through FIG. 5E show schematic diagrams of a user interface of the display device 110. The display device 110 may collect a large amount of measurement data of almost all electrical devices in the power distribution system, and may perform classified display without delay. As shown in FIG. 5A through FIG. 5E, by operating the virtual buttons on the right side of the user interface, the user can select a measurement parameter of the electrical device to be looked up from a multi-level menu, thereby displaying the corresponding parameter. Referring to FIG. 5A, the menu may be classified into two options: "load" and "alarm", wherein "load" may be associated with the measurement parameter of the electrical device, and "alarm" may be associated with a device fault notification. Referring to FIG. 5B, after the load is selected, the user interface enters a load page, including "Q1: Device 1" and "Q2: Device 2", where Q1 and Q2 may be the two different "device groups" mentioned above (each device group may include one or more electrical devices). For the sake of brevity, only two device groups Q1 and Q2 are shown, and device group Q1 has one device 1 and device group Q2 has one device 2. Referring to FIG. 5C, after Q1 is selected, the user interface enters the Q1 interface, which has an option "energy consumption" and an option "active power". Referring to FIG. 5D, after the option "energy consumption" is selected, the energy consumption parameter of the device 1 may be displayed. As shown in FIG. 5E, after the option "alarm" in FIG. 5A is selected, the display device may further display a historical record of device faults.

In an embodiment of the present disclosure, the measurement data is buffered in the display device by providing a data buffering function. Therefore, when the measurement data needs to be displayed to the user, the buffered measurement data may be directly obtained from the display device for display, and meanwhile an update request may be sent to obtain the updated data, thereby decoupling the data display from the data communication. The user needn't wait for a remote response and the user's experience is improved.

Fig. 6 illustrates an example block diagram of an example device 600 that can be used to implement an embodiment of the present disclosure. The device 600 may be implemented as the display device 110 of FIG. 1. The device 600 can be used to implement the method 200 shown in FIG. 2.

As shown, the device 600 includes a central processing unit (CPU) 601 which performs various appropriate acts and processing, based on a computer program instruction stored in a read-only memory (ROM) 602 or a computer program instruction loaded from a storage unit 608 to a random access memory (RAM) 603. The RAM 603 stores therein various programs and data required for operations of the device 600. The CPU 601, the ROM 602 and the RAM 603 are connected via a bus 604 with one another. An input/output (I/O) interface 605 is also connected to the bus 604.

The following components in the device 600 are connected to the I/O interface 605: an input unit 606 such as a keyboard, a mouse and the like; an output unit 607 such as various kinds of displays and a loudspeaker, etc.; a storage unit 608 such as a magnetic disk, an optical disk, and etc.; and a communication unit 609 such as a network card, a modem, and a wireless communication transceiver, etc. The communication unit 609 allows the device 600 to exchange information/ data with other devices through a computer network such as the Internet and/or various kinds of telecommunications networks.

The method 200 described above may be executed by the processing unit 601. For example, in some embodiments, the method 200 may be implemented as a computer software program or a computer program product that is tangibly included in a machine readable medium, e.g., a non-transient computer readable media such as the storage unit 608. In some embodiments, part or all of the computer programs may be loaded and/or mounted onto the device 600 via ROM 602 and/or communication unit 609. When the computer program is loaded to the RAM 603 and executed by the CPU 601, one or more steps of the method 200 as describe above can be executed. Alternatively, in other embodiments, the CPU 601 can be configured in any other appropriate manner (for example, by means of firmware) to execute the method 200.

Those skilled in the art would appreciate that, each step of the above method according to the present disclosure can be implemented via a general computing device, and they can be integrated on a single computing device or distributed over a network formed by a plurality of computing device. Optionally, they can be implemented by program code executable by a computing device, such that they can be stored on a storage device to be executed by a computing device, or they are produced as various integrated circuit modules, respectively, or a plurality of modules or steps therein is implemented by a single integrated circuit module. As such, the present disclosure is not limited to any particular combination of hardware and software.

It will be noted that although various units or sub-units of the apparatus have been mentioned in the above detailed description, such partitioning is not for limitation. In practice, according to the embodiments of the present invention, the features and functions of two or more units described above may be embodied in one unit. In turn, the features and functions of one unit described above may be further embodied in more units.

Those described above are only optional embodiments of the present disclosure, without limiting the present disclosure, and for those skilled in the art, the present disclosure may allow various modifications and changes. Within the spirits and principles, any amendment, equivalent substitution, improvement and the like shall be all covered within the protection scope of the present disclosure.

## Claims

1. A method for displaying measurement parameters, the method comprising:
in response to receiving an input signal indicating to display one or more measurement parameters of an electrical device, reading from a memory a first data associated with the one or more measurement parameters for display, and generating an update request for the first data;
sending the update request to the electrical device; and
in response to receiving, from the electrical device, a second data associated with the one or more measurement parameters, writing the second data to the memory as updated data to replace the first data.

2. The method according to claim 1, wherein sending the update request to the electrical device comprises:
determining a device group to which the electrical device belongs based on the electrical device whose one or more measurement parameters are involved in the update request;
pushing the update request into a request queue corresponding to the device group; and
sending the update request to the electrical device according to the request queue.

3. The method according to claim 2, wherein sending the update request to the electrical device according to the request queue comprises:
determining whether a value of a timer corresponding to the request queue is equal to zero, wherein the value equal to zero indicates a data transceiver for sending the update request is in an idle state; and
in response to the value of the timer being equal to zero, sending the update request to the electrical device via the data transceiver.

4. The method according to claim 3, further comprising:
in response to the update request being sent, the timer starts to keep time.

5. The method according to claim 4, further comprising:
in response to the value of the timer exceeding a threshold, removing the corresponding update request from the request queue, and resetting the timer to zero to send next update request, wherein the value exceeding the threshold indicates that the data transceiver has not received from the electrical device the second data as the updated data.

6. The method according to claim 4, further comprising:
in response to receiving the second data associated with the one or more measurement parameters from the electrical device, removing the corresponding update request from the request queue, and resetting the timer to zero to send next update request.

7. The method according to claim 1, further comprising:
in response to the data received from the electrical device being identified as a notification signal indicative of a fault, displaying information associated with the fault indicated by the notification signal.

8. The method according to claim 7, wherein displaying the information associated with the fault indicated by the notification signal comprises:
obtaining corresponding fault information through a look-up table based on the notification signal; and
displaying the obtained fault information.

9. The method according to claim 1, further comprising:
in response to the data received from the electrical device being identified as a control signal, performing a display-related operation or a communication-related operation based on the control signal.

10. The method according to claim 9, wherein the display-related operation comprises highlighting the display, and the communication-related operation comprises cutting off a communication connection with the electrical device.

11. The method according to claim 1, wherein sending the update request to the electrical device further comprises:
sending the update request to the electrical device via a wireless communication channel.

12. The method according to claim 11, wherein the wireless communication channel is a communication channel established using Zigbee technology.

13. The method according to any of claims 1-12, wherein the electrical device comprises a gateway for establishing a communication channel.

14. The method according to any of claims 1-12, wherein the electrical device comprises at least one of an electrical load and a power distribution device.

15. The method according to claim 13, further comprising:
receiving a character code from the gateway to display the character code as it is, the character code indicating descriptive information associated with the electrical device.

16. The method according to claim 15, wherein the character code is a Unicode encode.

17. An apparatus for displaying measurement parameters, comprising:
a processor; and
a memory coupled to the processor, the memory having stored therein instructions that, when executed by the processor, cause the apparatus to perform actions comprising:
in response to receiving an input signal indicating to display one or more measurement parameters of an electrical device, reading from a memory a first data associated with the one or more measurement parameters for display, and generating an update request for the first data;
sending the update request to the electrical device; and
in response to receiving, from the electrical device, a second data associated with the one or more measurement parameters, writing the second data to the memory as updated data to replace the first data.

18. The apparatus for displaying measurement parameters according to claim 17, wherein sending the update request to the electrical device comprises:
determining a device group to which the electrical device belongs based on the electrical device whose one or more measurement parameters are involved in the update request;
pushing the update request into a request queue corresponding to the device group; and
sending the update request to the electrical device according to the request queue.

19. The apparatus for displaying measurement parameters according to claim 18, wherein sending the update request to the electrical device according to the request queue comprises:
determining whether a value of a timer corresponding to the request queue is equal to zero, wherein the value equal to zero indicates a data transceiver for sending the update request is in an idle state; and
in response to the value of the timer being equal to zero, sending the update request to the electrical device via the data transceiver.

20. The apparatus for displaying measurement parameters according to claim 19, the actions further comprising:
in response to the update request being sent, the timer starts to keep time.

21. The apparatus for displaying measurement parameters according to claim 20, the actions further comprising
in response to the value of the timer exceeding a threshold, removing the corresponding update request from the request queue, and resetting the timer to zero to send next update request, wherein the value exceeding the threshold indicates that the data transceiver has not received from the electrical device the second data as the updated data.

22. The apparatus for displaying measurement parameters according to claim 20, the actions further comprising:
in response to receiving the second data associated with the one or more measurement parameters from the electrical device, removing the corresponding update request from the request queue, and resetting the timer to zero to send next update request.

23. The apparatus for displaying measurement parameters according to claim 17, the actions further comprising:
in response to the data received from the electrical device being identified as a notification signal indicative of a fault, displaying information associated with the fault indicated by the notification signal.

24. The apparatus for displaying measurement parameters according to claim 23, wherein displaying the information associated with the fault indicated by the notification signal comprises:
obtaining corresponding fault information through a look-up table based on the notification signal; and
displaying the obtained fault information.

25. The apparatus for displaying measurement parameters according to claim 17, the actions further comprising:
in response to the data received from the electrical device being identified as a control signal, performing a display-related operation or a communication-related operation based on the control signal.

26. The apparatus for displaying measurement parameters according to claim 25, wherein the display-related operation comprises highlighting the display, and the communication-related operation comprises cutting off a communication connection with the electrical device.

27. The apparatus for displaying measurement parameters according to claim 17, wherein sending the update request to the electrical device further comprises:
sending the update request to the electrical device via a wireless communication channel.

28. The apparatus for displaying measurement parameters according to claim 27, wherein the wireless communication channel is a communication channel established using Zigbee technology.

29. The apparatus for displaying measurement parameters according to any of claims 17-28, wherein the electrical device comprises a gateway for establishing a communication channel.

30. The apparatus for displaying measurement parameters according to any of claims 17-28, wherein the electrical device comprises at least one of an electrical load and a power distribution device.

31. The apparatus for displaying measurement parameters according to claim 29, the actions further comprising:
receiving a character code from the gateway to display the character code as it is, the character code indicating descriptive information associated with the electrical device.

32. The apparatus for displaying measurement parameters according to claim 31, wherein the character code is a Unicode encode.

33. The apparatus for displaying measurement parameters according to any of claims 17-28, further comprising:
a display unit configured to display the measurement parameters.
